(19) Europäisches Patentamt
European Patent Office
Office européen des brevets

(11) **EP 4 026 249 B1**

(12) **EUROPEAN PATENT SPECIFICATION**

(45) Date of publication and mention
of the grant of the patent:
**23.04.2025 Bulletin 2025/17**

(21) Application number: **19786776.5**

(22) Date of filing: **10.10.2019**

(51) International Patent Classification (IPC):
$H03M\ 13/13$ (2006.01)     $H03M\ 13/29$ (2006.01)

(52) Cooperative Patent Classification (CPC):
**H03M 13/13; H03M 13/2906**

(86) International application number:
**PCT/EP2019/077482**

(87) International publication number:
**WO 2021/069076 (15.04.2021 Gazette 2021/15)**

(54) **STAIRCASE CODING BASED ON POLAR CODES**

STAIRCASE-CODIERUNG AUF DER GRUNDLAGE VON POLAREN CODES

CODAGE EN ESCALIER BASÉ SUR DES CODES POLAIRES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**13.07.2022 Bulletin 2022/28**

(73) Proprietor: **Huawei Technologies Co., Ltd.**
**Longgang District**
**Shenzhen, Guangdong**
**518129 (CN)**

(72) Inventors:
• **BIOGLIO, Valerio**
**80992 Munich (DE)**
• **LAND, Ingmar**
**80992 Munich (DE)**
• **CONDO, Carlo**
**80992 Munich (DE)**

(74) Representative: **Roth, Sebastian**
**Mitscherlich PartmbB**
**Patent- und Rechtsanwälte**
**Karlstraße 7**
**80333 München (DE)**

(56) References cited:
**US-A1- 2018 226 999**

• ZHOU LIU ET AL: "Performance Analysis of Soft Decoding Algorithms for Polar-Staircase Coding Scheme", 2018 10TH INTERNATIONAL CONFERENCE ON WIRELESS COMMUNICATIONS AND SIGNAL PROCESSING (WCSP), IEEE, 18 October 2018 (2018-10-18), pages 1 - 6, XP033460256, DOI: 10.1109/WCSP.2018.8555862
• ZHOU LIU ET AL: "Performance Analysis of Soft Decoding Algorithms for Polar-Staircase Coding Scheme", 2018 10TH INTERNATIONAL CONFERENCE ON WIRELESS COMMUNICATIONS AND SIGNAL PROCESSING (WCSP), IEEE, 18 October 2018 (2018-10-18), pages 1 - 6, XP033460256, DOI: 10.1109/WCSP.2018.8555862
• BOWEN FENG ET AL: "A Novel High-Rate Polar-Staircase Coding Scheme", ARXIV.ORG, CORNELL UNIVERSITY LIBRARY, 201 OLIN LIBRARY CORNELL UNIVERSITY ITHACA, NY 14853, 25 May 2018 (2018-05-25), XP080882368
• DOU XIN ET AL: "Soft-Decision Based Sliding-Window Decoding of Staircase Codes", 2018 IEEE 10TH INTERNATIONAL SYMPOSIUM ON TURBO CODES & ITERATIVE INFORMATION PROCESSING (ISTC), IEEE, 3 December 2018 (2018-12-03), pages 1 - 5, XP033506468, DOI: 10.1109/ISTC.2018.8625265

- ALIREZA SHEIKH ET AL: "Binary Message Passing Decoding of Product-like Codes", ARXIV.ORG, CORNELL UNIVERSITY LIBRARY, 201 OLIN LIBRARY CORNELL UNIVERSITY ITHACA, NY 14853, 10 February 2019 (2019-02-10), XP081493687

## Description

TECHNICAL FIELD

In general, the present invention relates to data encoding in communication systems. More specifically, the present invention relates to an apparatus and method for encoding data using polar codes.

BACKGROUND

Channel codes are essential in all digital communications systems. A system for forward error correction (FEC) coding, also called a coding scheme, consists of an encoder at the transmitter side, and a decoder at the receiver side.

The encoder adds redundancy to the data to be transmitted, i.e. additional redundant data, and the decoder exploits this redundancy to correct transmission errors, such that the receiver obtains the transmitted data free of errors despite the noisy communication channel.

The data u to be transmitted, named information word, is given as input to the encoder, which produces the codeword x which contains redundancy. This is then transmitted over the noisy communication channel which typically introduces errors. The output vector y is provided to the decoder, which produces estimates of the transmitted codeword and the transmitted data. The set C of possible codewords is called the code, or channel code, and the following is particularly concerned with such a code.

Therefore, reliable transmission of data over noisy communication channels requires some kind of error correction coding to be used. Polar codes were shown to achieve the Shannon capacity of many channels (see, E. Arikan, "Channel polarization: A method for constructing capacity achieving codes for symmetric binary-input memoryless channels", IEEE Trans. on Inf. Theory, vol. 55, no. 7, pp. 3051-3073, July 2009).

In their original or classical construction as specified in the above mentioned work by Arikan, polar codes are based on the polarization effect generated by the Kronecker products of the following kernel:

$$T_2 = \begin{pmatrix} 1 & 0 \\ 1 & 1 \end{pmatrix}.$$

In general, a classical polar code of length $N$ and dimension $K$ is defined by a generator matrix $G_N = T_2^{\otimes n}$, $N = 2^n$, and a set of frozen bit indices $F \subset [N]$, $[N] = \{0,1,...,N-1\}$, wherein the size of the set of frozen bit indices $F$ is given by $|F| = N - K$. A set of $K$ information bit indices $I$ is defined as the complementary set of the set of frozen bit indices, namely $I = [N]/F$, and therefore $|I| = K$.

In order to encode the $K$ information bits into a polar code or codeword $c_N$ of length $N$, the elements $u_i$ of a binary input vector $u_N$ of length $N$ are set equal to zero for $i \in F$ and equal to the $K$ information bits for $i \in I$. Then, the encoded polar code $c_N$ can be obtained as:

$$c_N = u_N \cdot G_N.$$

According to the classical construction of polar codes, the effective generator matrix $G_N$ is a sub-matrix of $T_2^{\otimes n}$ formed by rows of $T_2^{\otimes n}$, denoting the n-fold Kronecker product. As a consequence, only polar codes having a length of powers of 2, namely $N = 2^n$, can be generated. Therefore, given a code dimension (i.e. number of information bits) $K$, classical polar codes admit only a polar code rate $R = K/N$, under the condition that $N$ is a power of 2. A simple implementation of the encoder requires n stages of XOR gates.

Therefore, polar codes are linear block codes that rely on the polarization effect, which allows to sort the bit positions of $u$, called bit-channels, in order of reliability. As the code length goes toward infinity, the polarization phenomenon influences the reliability of bit-channels, which are either completely noisy or completely noiseless; even more, the fraction of noiseless bit-channels equals the channel capacity.

For finite practical code lengths, the polarization of bit-channels is incomplete, therefore, there are bit-channels that are partially noisy.

Polar code decoding can be based on successive cancellation (SC) decoding algorithm (see the work by Arikan), which is inherently sequential. It can be viewed as a binary tree search, where bits are estimated at leaf nodes, and the tree is traversed depth-first, with priority given to the left branch. In SC decoding, the decoder starts with a decision for bit $u_1$ and feeds this decision back into the decoding process. Then, it makes a decision of bit $u_2$ and feeds this decision back into the decoding process.

It proceeds in this manner until it obtains the design for the last bit $u_N$. SC list decoding (SCL) (I. Tal and A. Vardy, "List decoding of polar codes," IEEE Transactions on Information Theory, vol. 61, no. 5, pp. 2213-2226, May 2015.) is an enhanced version of SC where multiple are followed during the decoding, while the decision is postponed to the end of the decoding process and is usually performed with the help of a CRC (A. Balatsoukas-Stimming, M. B. Parizi and A. Burg, "LLR-Based Successive Cancellation List Decoding of Polar Codes," in IEEE Transactions on Signal Processing, vol. 63, no. 19, pp. 5165-5179, Oct.1, 2015.).

Staircase codes were introduced in B. P. Smith et al. "Staircase Codes: FEC for 100 Gb/s OTN", in IEEE/OSA Journal of Lightwave Technology, vol. 30, no. 1, Jan 2012, targeting 100 Gb/s optical transport networks. Inspiration is taken from both product codes and convolutional codes, in that they combine the use of a block code as component code, and entangle part of it with past and future codewords, alternating row and column encoding/decoding.

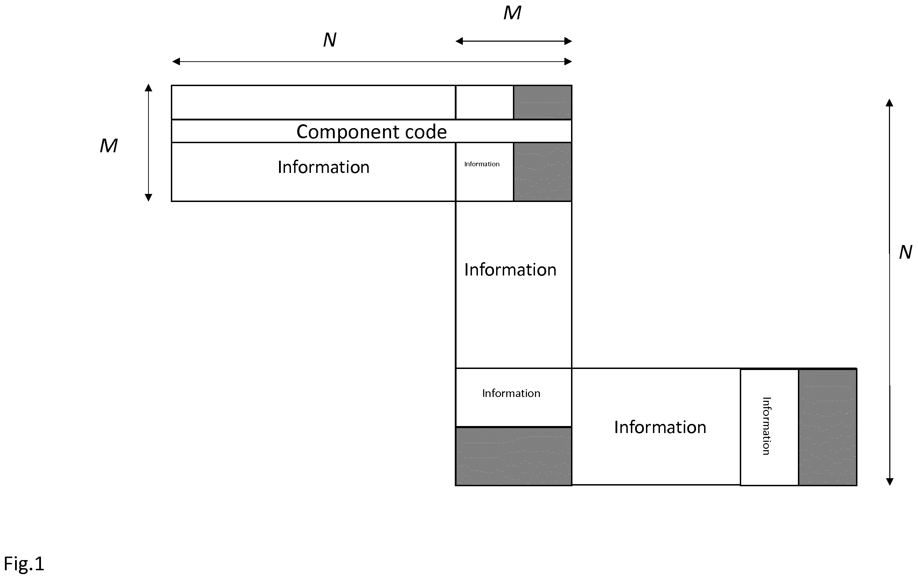

Fig. 1 depicts a straightforward example of staircase code. Encoding and transmission proceeds from the top left towards the bottom right. Bits belonging to multiple component codes are transmitted only once. When interpreted through this graphical representation, staircase codes natively make use of systematic component codes.

Decoding of staircase codes starts from the newest received blocks (bottom right in Fig. 1) propagating information towards the older blocks (top left). A decoding window of W blocks is selected for practical reasons, identifying the number of blocks through which the decoding information is propagated. Every time a new block is received, the oldest block in the window is output.

Staircase code decoding is possible both as hard-decoding and soft decoding. Hard decoding requires the decoding of component codes to return hard decisions, and the information propagated is the value of the bit itself. Soft decoding requires component code decoders to return soft values, which are scaled and propagated through the window. Hard decisions are taken only at output time. Soft decoding can achieve substantially better error-correction performance than hard decoding, at the cost of increased decoding complexity.

Preliminary results with staircase codes using polar codes have been presented in B. Feng et al. "A novel high-rate polar-staircase coding scheme," in arXiv preprint arXiv:1805.10082, 2018 and L. Zhou et al. "Performance Analysis of Soft Decoding Algorithms for Polar-Staircase Coding Scheme," 2018 10th International Conference on Wireless Communications and Signal Processing (WCSP), Hangzhou, 2018, where systematic polar codes are considered. Systematic polar codes are straightforward, but come with the disadvantage of increased encoding and decoding latency, that can be critical in optical communications.

Document "Soft-Decision Based Sliding-Window Decoding of Staircase Codes" by Dou et al. discloses staircase codes which are a class of braided block codes, which have been demonstrated to have good performance for high speed optical communication. In particular, it discloses a soft-decision decoding and a Chase-Pyndiah algorithm based sliding-window decoding for staircase codes over a AWGN channel.

Thus, there is a need for an improved apparatus and method for encoding and decoding data using polar codes.

SUMMARY

In view of the above-mentioned problems and disadvantages, embodiments of the present invention aim to improve the conventional polar codes and their construction methods. An objective is thereby to provide an improved apparatus for encoding data using polar codes.

The objective is achieved by the embodiments provided in the enclosed independent claims. Advantageous implementations of the embodiments are further defined in the dependent claims.

According to a first aspect, the invention relates to an apparatus for encoding a sequence including information bits into a sequence of matrices, wherein the apparatus is configured to generate a MxN matrix $U^N_h$, wherein M=N/2, wherein in each row $0 \leq i < M$ of $U^N_h$ each bit position $0 \leq j < M$ contains an information bit of the input sequence or a frozen bit depending on a set of frozen bit indices F of a polar code of length N associated with that row, wherein the bits $x_{ij}$, for $0 \leq i < M$ and $0 \leq j < N-M$ form a matrix $U_{h+1}$, while the bits $x_{ij}$ for $0 \leq i < M$ and $M \leq j < N$ form a matrix $X_h{'}$, encode each row of $U^N_h$ on the basis of the polar code of length N associated with that row, in order to obtain an encoded matrix $X^N_h$, wherein the bits $x_{ij}$ of $X^N_h$ for $0 \leq i < M$ and $0 \leq j < N-M$ form a matrix $X_{h+1}{'}$ while the bits $x_{ij}$ for $0 \leq i < M$ and $M \leq j < N$ form a matrix $X_h$, and transmit the matrix $X_h$.

Further, the apparatus is configured to generate a NxM matrix $U^N_{h+1}$, wherein in each column $0 \leq j < M$ of $U^N_{h+1}$ each bit position $0 \leq i < N$ contains an information bit of the input sequence or a frozen bit depending on a set of frozen bit indices F of the polar code of length N associated with that column, wherein the bits $x_{ij}$, for $0 \leq i < M$ and $0 \leq i < N-M$ form a matrix $U_{h+2}$, while the bits $x_{ij}$ for $0 \leq i < M$ and $N-M \leq i < N$ form the matrix $X_{h+1}{'}$, encode each column of $U^N_{h+1}$ on the basis of the polar code of length N associated with that column, in order to obtain an encoded matrix $X^N_{h+1}$, wherein the bits $x_{ij}$ of $X^N_{h+1}$ for $0 \leq j < M$ and $0 \leq i < N-M$ form a matrix $X_{h+2}{'}$ while the bits $x_{ij}$ for $0 \leq j < M$ and $N-M \leq j < N$ form a matrix $X_{h+1}$, transmit the matrix $X_{h+1}$. The polar encoding is based on a non-systematic polar encoding.

This provides the advantage that the polarization effects of polar codes can be used while encoding the sequence.

This provides the advantage that the polarization effects of polar codes can be used while encoding the sequence. Moreover the encoding is simple and fast.

Further, this provides the advantage that the staircase construction with non-systematic polar code design has the same error-correction performance of an equivalent construction with systematic polar codes, with simpler and faster component encoding.

In an implementation form of the apparatus according to the first aspect, the apparatus is further configured to generate a MxN matrix $U^N_{h+2}$, wherein in each row $0 \leq i < M$ of $U^N_{h+2}$ each bit position $0 \leq j < N-M$ contains an information bit of the input sequence or a frozen bit depending on the set of frozen bit indices F of the polar code of length N associated with that row, wherein the bits $x_{ij}$, for $0 \leq i < M$ and $0 \leq j < N-M$ form a matrix $U_{h+3}$, while the bits $x_{ij}$ for $0 \leq i < M$ and $N-M \leq j < N$ form the matrix $X_{h+2}{'}$, encode each row of $U^N_{h+2}$ on the basis of the polar code of length N associated with that row, in order to obtain an encoded matrix $X^N_{h+2}$, wherein the bits $x_{ij}$ of $X^N_{h+2}$ for $0 \leq i < M$ and $0 \leq j < N-M$ form a matrix $X_{h+3}{}'$ while the bits $x_{ij}$ for $0 \leq i < M$ and $N-M \leq j < N$ form a matrix $X_{h+2}$, transmit the matrix $X_{h+2}$.

This provides the advantage that the polarization effects of polar codes can be used while encoding the sequence. Moreover the encoding is simple and fast.

In an implementation form of the apparatus according to the first aspect, the apparatus is further configured to set to 0 all bits $x_{ij}$ for $j \geq N-M$ forming the matrix $X_0{}'$.

This provides the advantage that the matrix $X_0{}'$ can be initialized in a simple way.

In an implementation form of the apparatus according to the first aspect, for the polar code of length N, the apparatus is configured to choose K most reliable positions i, with $i < N-M$, as positions of information bits, freeze the remaining N-M-K positions with $i < N-M$, and put information bits in any position $i \geq N-M$.

In an implementation form of the apparatus according to the first aspect, for the polar code of length N and N-M being a power of 2, with N=2M, the apparatus is configured to select the K most reliable positions i as non-frozen positions from the frozen set of polar code of length N-M, wherein non-frozen positions correspond to positions of information bits, freeze the remaining N-M-K positions, and put information bits in any position $i \geq N-M$.

According to a second aspect, the invention relates to a method encoding an input sequence including information bits, wherein the method comprises the steps of generating a MxN matrix $U^N_h$, wherein M=N/2, wherein in each row $0 \leq i < M$ of $U^N_h$ each bit position $0 \leq j < M$ contains an information bit of the input sequence or a frozen bit depending on a set of frozen bit indices F of a polar code of length N associated with that row, wherein the bits $x_{ij}$, for $0 \leq i < M$ and $0 \leq j < M$ form a matrix $U_{h+1}$, while the bits $x_{ij}$ for $0 \leq i < M$ and $M \leq j < N$ form a matrix $X_h{}'$, encoding each row of $U^N_h$ on the basis of the polar code of length N associated with that row, in order to obtain an encoded matrix $X^N_h$, wherein the bits $x_{ij}$ of $X^N_h$ for $0 \leq i < M$ and $0 \leq j < M$ form a matrix $X_{h+1}{}'$ while the bits $x_{ij}$ for $0 \leq i < M$ and $M \leq j < N$ form a matrix $X_h$, and transmitting the matrix $X_h$.

The method further comprises generating a MxN matrix $U^N_{h+2}$, wherein in each row $0 \leq i < M$ of $U^N_{h+2}$ each bit position $0 \leq j < N-M$ contains an information bit of the input sequence or a frozen bit depending on the set of frozen bit indices F of the polar code of length N associated with that row, wherein the bits $x_{ij}$, for $0 \leq i < M$ and $0 \leq j < N-M$ form a matrix $U_{h+3}$, while the bits $x_{ij}$ for $0 \leq i < M$ and $N-M \leq j < N$ form the matrix $X_{h+2}{}'$, encoding each row of $U^N_{h+2}$ on the basis of the polar code of length N associated with that row, in order to obtain an encoded matrix $X^N_{h+2}$, wherein the bits $x_{ij}$ of $X^N_{h+2}$ for $0 \leq i < M$ and $0 \leq j < N-M$ form a matrix $X_{h+3}{}'$ while the bits $x_{ij}$ for $0 \leq i < M$ and $N-M \leq j < N$ form a matrix $X_{h+2}$ and transmitting the matrix $X_{h+2}$. The polar encoding is based on a non-systematic polar encoding

In an implementation form of the second aspect, the method further comprises generating a NxM matrix $U^N_{h+1}$, wherein in each column $0 \leq i < M$ of $U^N_{h+1}$ each bit position $0 \leq i < N$ contains an information bit of the input sequence or a frozen bit depending on a set of frozen bit indices F of the polar code of length N associated with that column, wherein the bits $x_{ij}$, for $0 \leq j < M$ and $0 \leq i < N-M$ form a matrix $U_{h+2}$, while the bits $x_{ij}$ for $0 \leq j < M$ and $N-M \leq i < N$ form the matrix $X_{h+1}{}'$, encoding each column of $U^N_{h+1}$ on the basis of the polar code of length N associated with that column, in order to obtain an encoded matrix $X^N_{h+1}$, wherein the bits $x_{ij}$ of $X^N_{h+1}$ for $0 \leq i < M$ and $0 \leq i < N-M$ form a matrix $X_{h+2}{}'$ while the bits $x_{ij}$ for $0 \leq j < M$ and $N-M \leq j < N$ form a matrix $X_{h+1}$ and transmitting the matrix $X_{h+1}$.

The method of the second aspect and its respective implementation forms provide the same advantages and effects as described above for the respective apparatus of the first aspect and its respective implementation forms.

It has to be noted that all devices, elements, units and means described in the present application could be implemented in the software or hardware elements or any kind of combination thereof. All steps which are performed by the various entities described in the present application as well as the functionalities described to be performed by the various entities are intended to mean that the respective entity is adapted to or configured to perform the respective steps and functionalities.

Even if, in the following description of specific embodiments, a specific functionality or step to be performed by external entities is not reflected in the description of a specific detailed element of that entity which performs that specific step or functionality, it should be clear for a skilled person that these methods and functionalities can be implemented in respective software or hardware elements, or any kind of combination thereof.

BRIEF DESCRIPTION OF DRAWINGS

The above described aspects and implementation forms of the present invention will be explained in the following description of specific embodiments in relation to the enclosed drawings, in which:

FIG. 1 shows a schematic representation of an exemplary straightforward staircase construction;
FIG. 2 shows a schematic representation of a communication system comprising an apparatus according to an embodiment;
FIG. 3 shows a schematic representation of a staircase construction with non-systematic polar codes according to an embodiment;
FIG. 4 shows a schematic representation of a staircase construction with non-systematic polar codes according to an embodiment;
FIG. 5 shows a schematic representation of a staircase construction with non-systematic polar codes according to an embodiment;

FIG. 6 shows a schematic representation of a staircase construction with non-systematic polar codes according to an embodiment;

FIG. 7 shows a schematic representation of a staircase construction with non-systematic polar codes according to an embodiment;

FIG. 8 shows a schematic representation of a decoding scheme for decoding a staircase code encoded according to the invention;

FIG. 9 shows a schematic representation of a method for encoding an input sequence including information bits according to an embodiment; and

FIG. 10 shows a schematic representation of a method for decoding an input sequence including information bits for decoding a staircase code encoded according to the invention.

<u>DETAILED DESCRIPTION OF EMBODIMENTS</u>

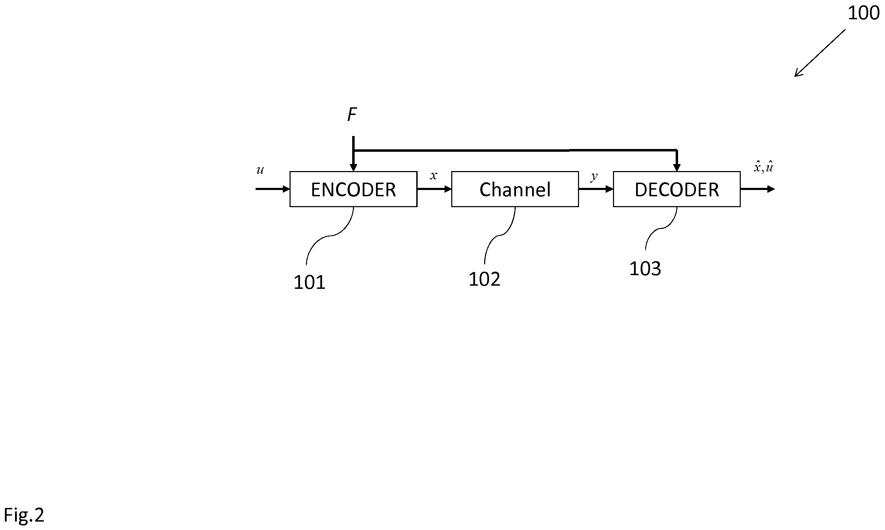

FIG. 2 shows a schematic representation of a communication system 100 comprising an apparatus 101 according to an embodiment.

The apparatus 101 is configured to encode a sequence including information bits into a sequence of matrices. The apparatus is further configured to:

- generate a MxN matrix $U^N_h$, wherein M=N/2, wherein in each row $0 \le i < M$ of $U^N_h$ each bit position $0 \le j < M$ contains an information bit of the input sequence or a frozen bit depending on a set of frozen bit indices F of a polar code of length N associated with that row, wherein the bits $x_{ij}$, for $0 \le i < M$ and $0 \le j < N-M$ form a matrix $U_{h+1}$, while the bits $x_{ij}$ for $0 \le i < M$ and $M \le j < N$ form a matrix $X_h{}'$;

- encode each row of $U^N_h$ on the basis of the polar code of length N associated with that row, in order to obtain an encoded matrix $X^N_h$, wherein the bits $x_{ij}$ of $X^N_h$ for $0 \le i < M$ and $0 \le j < N-M$ form a matrix $X_{h+1}{}'$ while the bits $x_{ij}$ for $0 \le i < M$ and $M \le j < N$ form a matrix $X_h$;

- transmit the matrix $X_h$.

In FIG. 2, the vector u comprises information bits and frozen bits and is encoded into a codeword x. After propagation over the communication channel 102, the codeword x is changed into the codeword y due to the noise of the communication channel 102.

The apparatus or decoder 103 is configured to decode the codeword y in order to recover the originally sent sequence or vector u.

The apparatus or decoder 103 is configured to decode a sequence of bits from a sequence of matrices $\Lambda_k$, k=0,..,W received over the communication channel 102 and resulting from a transmission of the sequence of bits encoded in a sequence of matrices $X_h$, h=1,..., W over the communication channel 102.

The apparatus 103 is configured to:

- propagate logarithmic likelihood ratios (LLRs) of $\Lambda_w$ in order to obtain a LLRs matrix, wherein the LLRs of $\Lambda_w$ are related to an encoded matrix $X_w$;

- concatenate an interleaver $\Pi$ to the LLRs matrix in order to obtain a matrix $\Lambda'_w$ related to an encoded matrix $X'_w$;

- prepend $\Lambda'_w$ to a matrix $\Lambda_{w-1}$ in order to obtain a matrix $D_W$, wherein $\Lambda_{w-1}$ is related to an encoded matrix $X_{w-1}$;

- decode each column of $D_w$ on the basis of a polar code decoding algorithm in order to obtain a matrix $\Gamma_w$;

- compute an updated matrix $\Lambda_{w-1}$ as:

$$\Lambda_{w-1} = \Gamma_w + Y_{W-1},$$

wherein $Y_{W-1}$ comprises LLRs originally received from the communication channel 102 after the transmission of a matrix $X_{w-1}$.

In an embodiment, optical transport network are considered whose error-correction performance requirements demand that a soft-decoding approach is taken at the receiver.

According to the invention, a staircase code is designed using non-systematic polar codes. Given the nature of polar codes, the direction of encoding and decoding in the staircase can be inverted.

There is no constraint on the number of component codes M that each block of the staircase contains, except that M=N/2.

The codeword length N is imposed by the component code. Polar codes have code lengths equal to powers of 2, but shortening and puncturing techniques, and multi-kernel designs, can be used in order to obtain different lengths of polar codes.

Moreover, the frozen set F of the polar code can be selected in two ways:

1) from the frozen set of the polar code of length N, the K most reliable positions i with i<(N-M) as non-frozen positions can be selected. The remaining N-M-K positions with i<(N-M) are frozen. Any position i≥N-M is treated as an information position; and

2) in case N-M is a power of 2, from the frozen set of the polar code of length N-M, the K most reliable positions i can be selected as non-frozen positions. The remaining N-M-K positions are frozen. Any position i≥N-M is treated as an information position.

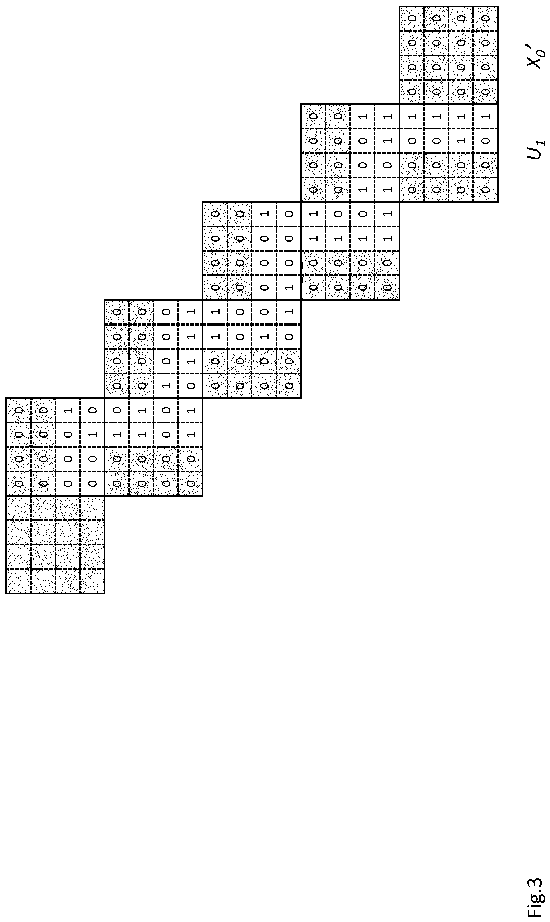

In order to better understand the different steps of the encoding, different steps of the encoding process are portrayed in FIGs. 3-7 for an example where *M=N/2, N=8, M=4.*

In this embodiment, the N-bit input vector *u* to the polar encoder is composed of a first part $u_{new}$ of *N-M* bits, where information bits are placed, and a second part x' that is composed of previously encoded bits.

All frozen bits are placed in $u_{new}$: consequently, F has frozen bits in the $N-M-K$ least reliable positions among the leftmost $N-M$ bit positions.

$M$ input vectors $u$ compose an input matrix $U$. Let us build an input matrix $U^N_0$, where in every row $0 \leq i < M$ each bit position $0 \leq j < N-M$ is an information or a frozen bit according to $F$, while all bit positions $j > N-M$ are set to 0.

The leftmost part of $U^N_0$ is called $U_1$, while the rightmost part is $X_0'$ (see FIG. 3).

The apparatus 101 can be configured to set to 0 all bits $x_{ij}$ for $j \geq N-M$ forming the matrix $X_0'$.

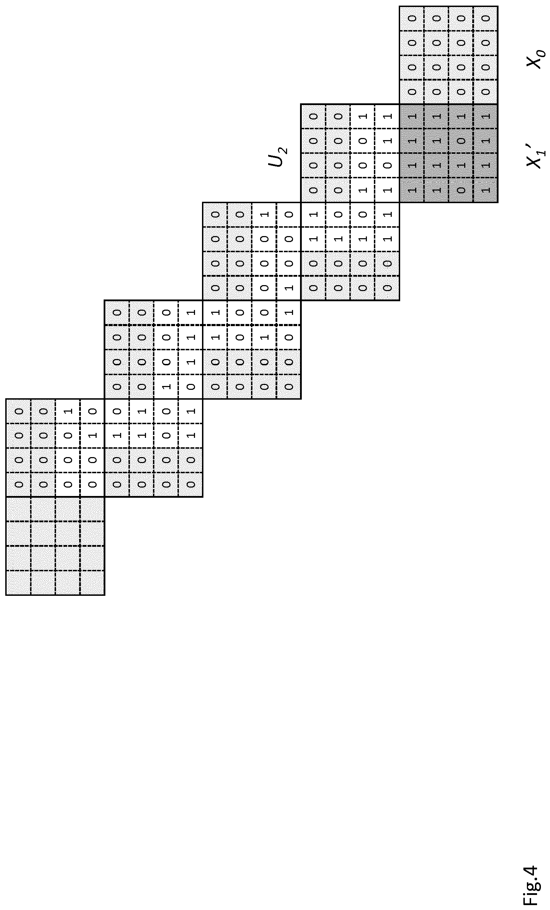

The apparatus 101 can be configured to encode each row of $U$ and obtain the encoded matrix $X^N_0$: the rightmost $MxM$ matrix is called $X_0$, and the leftmost part is called $X_1'$ (see FIG. 4).

Afterwards, the apparatus 101 is configured to transmit the matrix $X_0$.

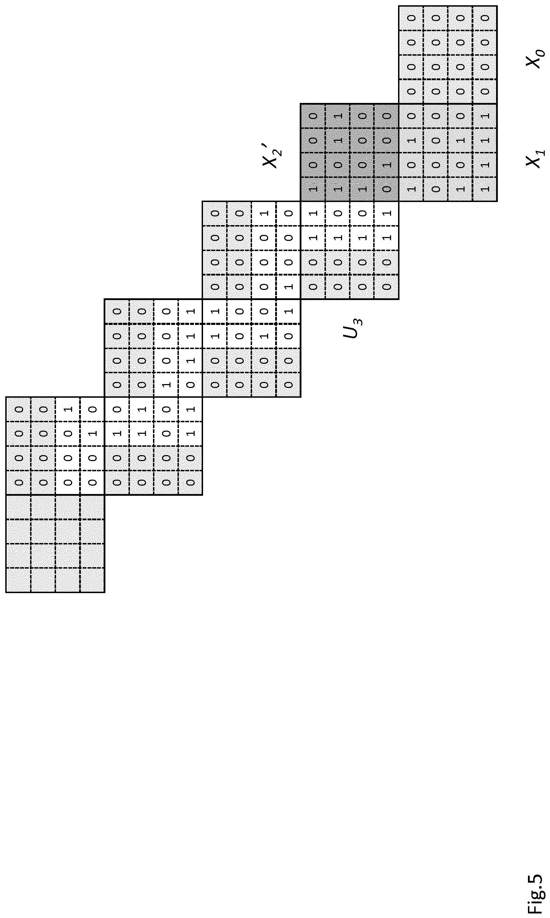

Furthermore, the apparatus 101 con be configured to generate $L^N_1$ through a set of column input vectors $U_2$ and the columns of $X_1'$. After encoding, $X^N_1$ can be obtained, with $X_1$ on the right side and $X_2'$ on the left side (see FIG. 5). Then, $X_1$ can be transmitted.

Furthermore, the apparatus 101 can be configured to perform the following steps:

- generate a MxN matrix $U^N_2$, wherein in each row $0 \leq i < M$ of $U^N_2$ each bit position $0 \leq j < N-M$ contains an information bit of the input sequence or a frozen bit depending on the set of frozen bit indices F of the polar code of length N associated with that row, wherein the bits $x_{ii}$, for $0 \leq i < M$ and $0 \leq j < N-M$ form a matrix $U_3$, while the bits $x_{ij}$ for $0 \leq i < M$ and $N-M \leq j < N$ form the matrix $X_2'$;

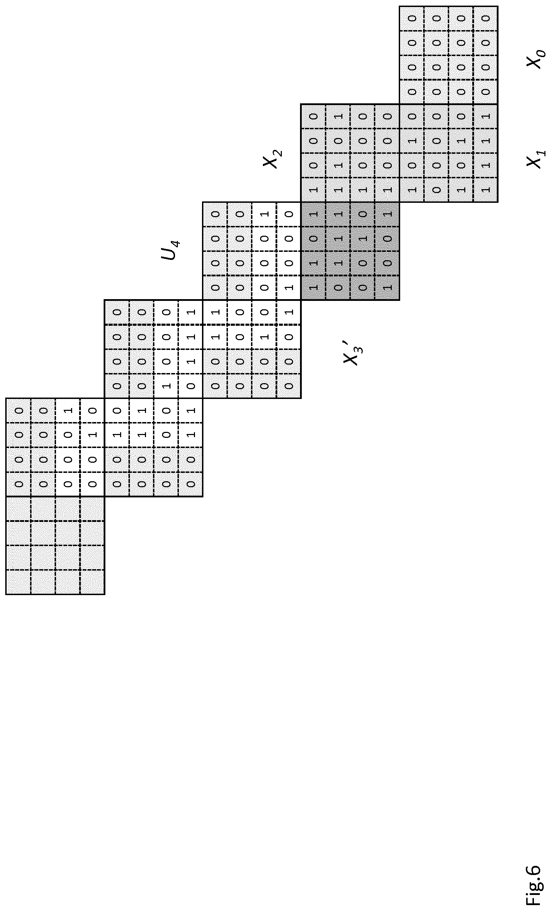

- encode each row of $U^N_2$ on the basis of the polar code of length N associated with that row, in order to obtain an encoded matrix $X^N_2$, wherein the bits $x_{ij}$ of $X^N_2$ for $0 \leq i < M$ and $0 \leq j < N-M$ form a matrix $X_3'$ while the bits $x_{ij}$ for $0 \leq i < M$ and $N-M \leq j < N$ form a matrix $X_2$ (see FIG. 6);

- transmit the matrix $X_2$.

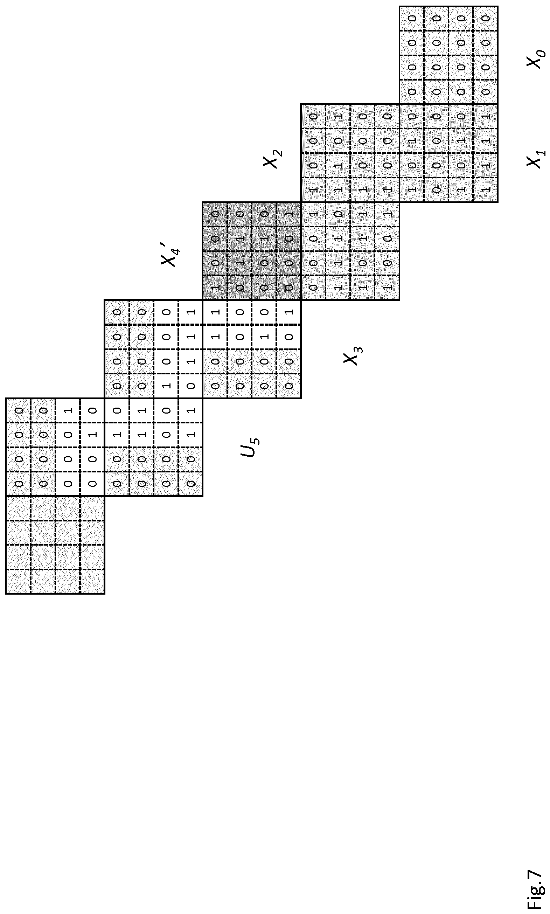

The process is repeated alternating row and column encoding (see further FIG. 7). Each component encoding is a standard non-systematic polar code encoder, which has half the systematic encoder latency.

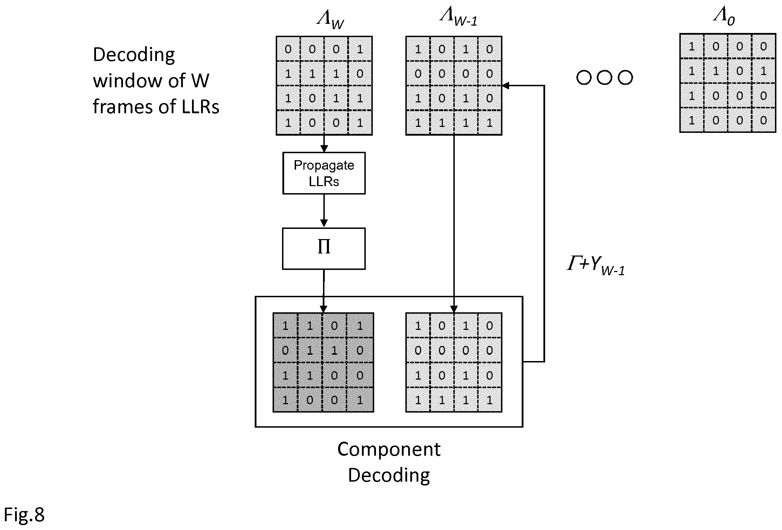

FIG. 8 shows a schematic representation of a decoding scheme for decoding a staircase code encoded according to the invention.

On the receiver side, the decoder or apparatus 103 receives a set of logarithmic likelihood ratios (LLRs) A for each transmitted matrix $X$.

Then, the apparatus 103 can be configured to store matrices $\Lambda_k$, $0 \leq k \leq W$ representing a decoding window of $W+1$ frames. While it is implemented as a circular buffer, the received frame can be stored in $\Lambda_W$ and the oldest frame can be stored in $\Lambda_0$. $\Lambda_1$ is the one output from the decoder 103, but to decode it, the information stored in frame $\Lambda_0$ can be used.

The LLRs of $\Lambda_W$ are relative to the encoded matrix $X_w$, which can be assumed as being last encoded by rows. $\Lambda_{W-1}$ is relative instead to $X_{W-1}$, encoded by columns.

In order to decode $\Lambda_{W-1}$ by columns, the LLRs in $\Lambda_W$ should be changed from representing $X_W$ to representing $X_W'$, which was last encoded by columns. This can be done by the propagate LLRs function, concatenated with an interleaver $\Pi$. The interleaver rotates the LLR matrix of 90 degrees clockwise or anti-clockwise, depending if we are converting a row-encoded matrix for column decoding or vice versa.

Thus, after obtaining $\Lambda_W'$, relative to $X_W'$, the apparatus 103 can be configured to prepend it to $\Lambda_{W-1}$, and decode each column.

The component decoding takes each column separately: any polar code decoding algorithm can be used, as long as soft values can be inferred from it. Component decoding of non-systematic polar codes is inherently faster than the systematic case.

The component decoding process returns a matrix of extrinsic values $\Gamma$. The updated $\Lambda_{W-1}$ is computed as $\Lambda_{W-1} = \Gamma + Y_{W-1}$ where $Y_{W-1}$ stores the LLRs originally received from the communication channel 102 after the transmission of $X_{W-1}$.

$\Lambda_W$ is not updated, as back-propagating information is damaging, an effect exacerbated by the propagate LLRs function.

In the next decoding step, $\Lambda_{W-1}$ and $\Lambda_{W-2}$ should be considered, with the LLRs in $\Lambda_{W-1}$ being propagated to identify $X_{W-1}'$, and thus enable row decoding of $\Lambda_{W-1}'$ and $\Lambda_{W-2}$. The process is repeated alternating row and column decoding, until $\Lambda_1$ is decoded with $\Lambda_0$: the output of the decoding iteration is then the estimated $\hat{U}_1$.

The LLRs are propagated by applying soft encoding process to a vector of LLRs, where the box-plus operation substitutes the XOR.

The box-plus operation between a and b is defined as:

$\min(|a|,|b|) \times \text{sign}(a) \times \text{sign}(b)$.

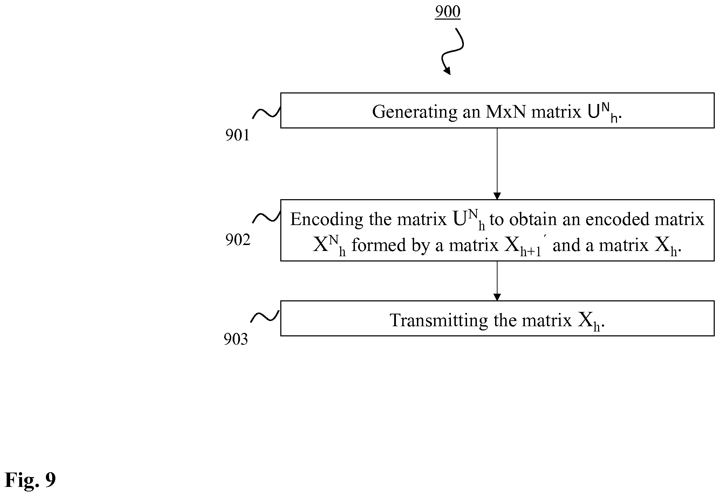

FIG. 9 shows a schematic representation of a method 900 for encoding an input sequence including information bits according to an embodiment.

The method comprises the steps of:

- generating 901 an MxN matrix $U^N_h$, wherein M=N/2, wherein in each row $0 \leq i < M$ of $U^N_h$ each bit position $0 \leq j < M$ contains an information bit of the input sequence or a frozen bit depending on a set of frozen bit indices F of a polar code of length N associated with that row, wherein the bits $x_{ij}$, for $0 \leq i < M$ and $0 \leq j < M$ form a matrix $U_{h+1}$, while the bits $x_{ij}$ for $0 \leq i < M$ and $M \leq j < N$ form a matrix $X_h'$;

- encoding 902 each row of $U^N_h$ on the basis of the polar code of length N associated with that row, in order to obtain an encoded matrix $X^N_h$, wherein the bits $x_{ij}$ of $X^N_h$ for $0 \leq i < M$ and $0 \leq j < M$ form a first matrix $X_{h+1}'$ while the bits $x_{ij}$ for $0 \leq i < M$ and $M \leq j < N$ form a second matrix $X_h$; and
- transmitting 903 the matrix $X_h$.

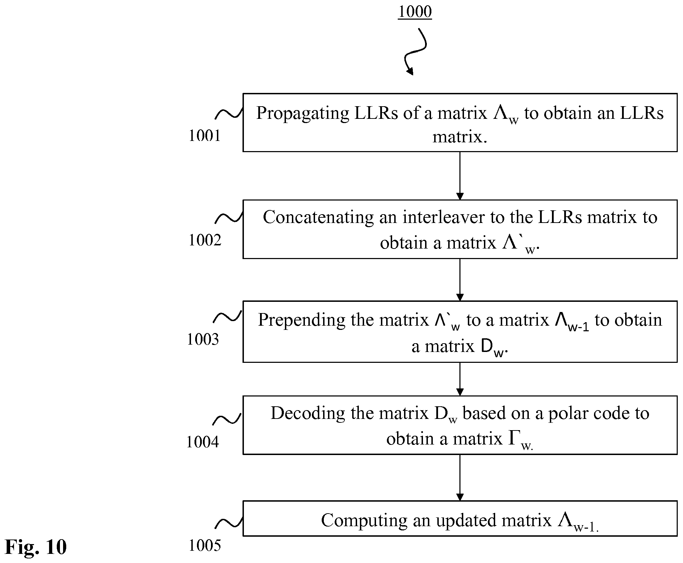

FIG. 10 shows a schematic representation of a method 1000 for decoding an input sequence including information bits from a sequence of matrices $\Lambda_k$ which has been encoded according to the invention.

The sequence of matrices $\Lambda_k$, $k=0,..,W$ is received over a communication channel 102 and results from a transmission of the sequence of bits encoded in a sequence of matrices $X_h$, $h=1,...,W$ over the communication channel 102.

The method 1000 comprises the steps of:

- propagating 1001 logarithmic likelihood ratios (LLRs) of $\Lambda_w$ in order to obtain a LLRs matrix, wherein the LLRs of $\Lambda_w$ are related to an encoded matrix $X_w$;
- concatenating 1002 an interleaver $\Pi$ to the LLRs matrix in order to obtain a matrix $\Lambda'_w$ related to an encoded matrix $X'_w$;
- prepending 1003 $\Lambda'_w$ to a matrix $\Lambda_{w-1}$ in order to obtain a matrix $D_w$, wherein $\Lambda_{w-1}$ is related to an encoded matrix $X_{w-1}$;
- decoding 1004 each column of $D_w$ on the basis of a polar code decoding algorithm in order to obtain a matrix $\Gamma_w$; and
- computing 1005 an updated matrix $\Lambda_{w-1}$ as:

$$\Lambda_{w-1} = \Gamma_w + Y_{W-1},$$

wherein $Y_{W-1}$ comprises LLRs originally received from the communication channel 102 after the transmission of a matrix $X_{w-1}$.

The apparatuses described above may comprise hardware and software which are configured to carry out the above described operations. The hardware may comprise digital circuitry. Digital circuitry may comprise components such as application-specific integrated circuits (ASICs), field-programmable arrays (FPGAs), digital signal processors (DSPs), or general-purpose processors. In one embodiment, the processing circuitry comprises one or more processors and a non-transitory memory connected to the one or more processors. The non-transitory memory may carry executable program code which, when executed by the one or more processors, causes the apparatus to perform the operations or methods described herein.

The present invention has been described in conjunction with various embodiments as examples as well as implementations. However, other variations can be understood and effected by those persons skilled in the art and practicing the claimed invention, from the studies of the drawings, this disclosure and the independent claims. In the claims as well as in the description the word "comprising" does not exclude other elements or steps and the indefinite article "a" or "an" does not exclude a plurality. A single element or other unit may fulfill the functions of several entities or items recited in the claims. The mere fact that certain measures are recited in the mutual different dependent claims does not indicate that a combination of these measures cannot be used in an advantageous implementation.

## Claims

1. An apparatus (101) for encoding a sequence including information bits into a sequence of matrices, wherein the apparatus (101) is configured to:

   - generate a MxN matrix $U^N_h$, wherein M=N/2, wherein in each row $0 \leq i < M$ of $U^N_h$ each bit position $0 \leq j < M$ contains an information bit of the input sequence or a frozen bit depending on a set of frozen bit indices F of a polar code of length N associated with that row, wherein the bits $x_{ij}$, for $0 \leq i < M$ and $0 \leq j < N-M$ form a matrix $U_{h+1}$, while the bits $x_{ij}$ for $0 \leq i < M$ and $M \leq j < N$ form a matrix $X_h'$;
   - encode each row of $U^N_h$ on the basis of the polar code of length N associated with that row, in order to obtain an encoded matrix $X^N_h$, wherein the bits $x_{ij}$ of $X^N_h$ for $0 \leq i < M$ and $0 \leq j < N-M$ form a matrix $X_{h+1}'$ while the bits $x_{ij}$ for $0 \leq i < M$ and $M \leq j < N$ form a matrix $X_h$;
   - transmit the matrix $X_h$;
   - generate a NxM matrix $U^N_{h+1}$, wherein in each column $0 \leq j < M$ of $U^N_{h+1}$ each bit position $0 \leq i < N$ contains an information bit of the input sequence or a frozen bit depending on a set of frozen bit indices F of the polar code of length N associated with that column, wherein the bits $x_{ij}$, for $0 \leq j < M$ and $0 \leq j < N-M$ form a matrix $U_{h+2}$, while the bits $x_{ij}$ for $0 \leq j < M$ and $N-M \leq i < N$ form the matrix $X_{h+1}'$;
   - encode each column of $U^N_{h+1}$ on the basis of the polar code of length N associated with that column, in order to obtain an encoded matrix $X^N_{h+1}$, wherein the bits $x_{ij}$ of $X^N_{h+1}$ for $0 \leq j < M$ and $0 \leq i < N-M$ form a matrix $X_{h+2}'$ while the bits $x_{ij}$ for $0 \leq j < M$ and $N-M \leq j < N$ form a matrix $X_{h+1}$;
   - transmit the matrix $X_{h+1}$; and
   - wherein the polar encoding is based on a non-systematic polar encoding.

2. The apparatus (101) of claim 1, wherein the apparatus (101) is further configured to:

   - generate a MxN matrix $U^N_{h+2}$, wherein in each

row $0 \leq i < M$ of $U^N_{h+2}$ each bit position $0 \leq j < N-M$ contains an information bit of the input sequence or a frozen bit depending on the set of frozen bit indices F of the polar code of length N associated with that row, wherein the bits $x_{ij}$, for $0 \leq i < M$ and $0 \leq j < N-M$ form a matrix $U_{h+3}$, while the bits $x_{ij}$ for $0 \leq i < M$ and $N-M \leq j < N$ form the matrix $X_{h+2}'$;

- encode each row of $U^N_{h+2}$ on the basis of the polar code of length N associated with that row, in order to obtain an encoded matrix $X^N_{h+2}$, wherein the bits $x_{ij}$ of $X^N_{h+2}$ for $0 \leq i < M$ and $0 \leq j < N-M$ form a matrix $X_{h+3}'$ while the bits $x_{ij}$ for $0 \leq i < M$ and $N-M \leq j < N$ form a matrix $X_{h+2}$;

- transmit the matrix $X_{h+2}$.

3. The apparatus (101) of claim 1, wherein the apparatus (101) is further configured to:

- set to 0 all bits $x_{ij}$ for $j \geq N-M$ forming the matrix $X_0'$.

4. The apparatus (101) of any one of the preceding claims, wherein, for the polar code of length N, the apparatus is configured to:

- choose K most reliable positions i, with $i < N-M$, as positions of information bits;
- freeze the remaining N-M-K positions with $i < N-M$; and
- put information bits in any position $i \geq N-M$.

5. The apparatus (101) of any one of the preceding claims 1 to 4, wherein, for the polar code of length N and N-M being a power of 2, the apparatus (101) is configured to:

- select the K most reliable positions i as non-frozen positions from the frozen set of polar code of length N-M, wherein non-frozen positions correspond to positions of information bits;
- freeze the remaining N-M-K positions; and
- put information bits in any position $i \geq N-M$.

6. A method (900) for encoding a an input sequence including information bits, wherein the method (900) comprises the steps of:

- generating (901) a MxN matrix $U^N_h$, wherein M=N/2, wherein in each row $0 \leq i < M$ of $U^N_h$ each bit position $0 \leq j < M$ contains an information bit of the input sequence or a frozen bit depending on a set of frozen bit indices F of a polar code of length N associated with that row, wherein the bits $x_{ij}$, for $0 \leq i < M$ and $0 \leq j < M$ form a matrix $U_{h+1}$, while the bits $x_{ij}$ for $0 \leq i < M$ and $M \leq j < N$ form a matrix $X_h'$;
- encoding (902) each row of $U^N_h$ on the basis of the polar code of length N associated with that row, in order to obtain an encoded matrix $X^N_h$, wherein the bits $x_{ij}$ of $X^N_h$ for $0 \leq i < M$ and $0 \leq j < M$ form a matrix $X_{h+1}'$ while the bits $x_{ij}$ for $0 \leq i < M$ and $M \leq j < N$ form a matrix $X_h$;

- transmitting (903) the matrix $X_h$;

- generating a NxM matrix $U^N_{h+1}$, wherein in each column $0 \leq j < M$ of $U^N_{h+1}$ each bit position $0 \leq i < N$ contains an information bit of the input sequence or a frozen bit depending on a set of frozen bit indices F of the polar code of length N associated with that column, wherein the bits $x_{ij}$, for $0 \leq j < M$ and $0 \leq i < N-M$ form a matrix $U_{h+2}$, while the bits $x_{ij}$ for $0 \leq j < M$ and $N-M \leq i < N$ form the matrix $X_{h+1}'$;

- encoding each column of $U^N_{h+1}$ on the basis of the polar code of length N associated with that column, in order to obtain an encoded matrix $X^N_{h+1}$, wherein the bits $x_{ij}$ of $X^N_{h+1}$ for $0 \leq j < M$ and $0 \leq i < N-M$ form a matrix $X_{h+2}'$ while the bits $x_{ij}$ for $0 \leq j < M$ and $N-M \leq i < N$ form a matrix $X_{h+1}$;

- transmitting the matrix $X_{h+1}$;

and wherein the polar encoding is based on a non-systematic polar encoding.

7. The method (900) of claim 6, wherein the method (900) further comprises:

- generating a MxN matrix $U^N_{h+2}$, wherein in each row $0 \leq i < M$ of $U^N_{h+2}$ each bit position $0 \leq j < N-M$ contains an information bit of the input sequence or a frozen bit depending on the set of frozen bit indices F of the polar code of length N associated with that row, wherein the bits $x_{ij}$, for $0 \leq i < M$ and $0 \leq j < N-M$ form a matrix $U_{h+3}$, while the bits $x_{ij}$ for $0 \leq i < M$ and $N-M \leq j < N$ form the matrix $X_{h+2}'$;

- encoding each row of $U^N_{h+2}$ on the basis of the polar code of length N associated with that row, in order to obtain an encoded matrix $X^N_{h+2}$, wherein the bits $x_{ij}$ of $X^N_{h+2}$ for $0 \leq i < M$ and $0 \leq j < N-M$ form a matrix $X_{h+3}'$ while the bits $x_{ij}$ for $0 \leq i < M$ and $N-M \leq j < N$ form a matrix $X_{h+2}$;

- transmitting the matrix $X_{h+2}$.

8. A computer program comprising program code which causes a computer to perform one of the methods of claims 6 to 7 when the program code is executed by the computer.

**Patentansprüche**

1. Vorrichtung (101) zum Codieren einer Informationsbits enthaltenden Folge in eine Folge von Matrizen, wobei die Vorrichtung (101) zu Folgendem konfiguriert ist:

- Erzeugen einer MxN-Matrix $U^N_h$, wobei M=N/2, wobei in jeder Zeile $0 \leq i < M$ von $U^N_h$ jede Bitposition $0 \leq j < M$ in Abhängigkeit von einer Menge gefrorener Bitindizes F eines Polarcodes der Länge N, der dieser Zeile zugeordnet ist, ein Informationsbit der Eingabefolge oder ein eingefrorenes Bit enthält, wobei die Bits $x_{ij}$ mit $0 \leq i < M$ und $0 \leq j < N-M$ eine Matrix $U_{h+1}$ bilden, während die Bits $x_{ij}$ mit $0 \leq i < M$ und $M \leq j < N$ eine Matrix $X_h$ bilden;

- Codieren jeder Zeile von $U^N_h$ auf Basis des Polarcodes der Länge N, der dieser Zeile zugeordnet ist, um so eine codierte Matrix $X^N_h$ zu erhalten, wobei die Bits $x_{ij}$ von $X^N_h$ mit $0 \leq i < M$ und $0 \leq j < N-M$ eine Matrix $X_{h+1}$ bilden, während die Bits $x_{ij}$ mit $0 \leq i < M$ und $M \leq j < N$ eine Matrix $X_h$ bilden;

- Übertragen der Matrix $X_h$;

- Erzeugen einer NxM-Matrix $U^N_{h+1}$, wobei in jeder Spalte $0 \leq i < M$ von $U^N_{h+1}$ jede Bitposition $0 \leq j < M$ in Abhängigkeit von einer Menge gefrorener Bitindizes F eines Polarcodes der Länge N, der dieser Spalte zugeordnet ist, ein Informationsbit der Eingabefolge oder ein gefrorenes Bit enthält, wobei die Bits $x_{ij}$ mit $0 \leq i < M$ und $0 \leq j < N-M$ eine Matrix $U_{h+2}$ bilden, während die Bits $x_{ij}$ mit $0 \leq i < M$ und $M \leq j < N$ die Matrix $X_{h+1}$ bilden;

- Codieren jeder Spalte von $U^N_{h+1}$ auf Basis des Polarcodes der Länge N, der dieser Spalte zugeordnet ist, um so eine codierte Matrix $X^N_{h+1}$ zu erhalten, wobei die Bits $x_{ij}$ von $X^N_{h+1}$ mit $0 \leq j < M$ und $0 \leq i < N-M$ eine Matrix $X_{h+2}$ bilden, während die Bits $x_{ij}$ mit $0 \leq j < M$ und $N-M \leq j < N$ eine Matrix $X_{h+1}$ bilden;

- Übertragen der Matrix $X_{h+1}$; und

- wobei die Polarcodierung auf einer nicht-systematischen Polarcodierung basiert.

2. Vorrichtung (101) nach Anspruch 1, wobei die Vorrichtung (101) ferner zu Folgendem konfiguriert ist:

- Erzeugen einer MxN-Matrix $U^N_{h+2}$, wobei in jeder Zeile $0 \leq i < M$ von $U^N_{h+2}$ jede Bitposition $0 \leq j < N-M$ in Abhängigkeit von der Menge gefrorener Bitindizes F des Polarcodes der Länge N, der dieser Zeile zugeordnet ist, ein Informationsbit der Eingabefolge oder ein gefrorenes Bit enthält, wobei die Bits $x_{ij}$ mit $0 \leq i < M$ und $0 \leq j < N-M$ eine Matrix $U_{h+3}$ bilden, während die Bits $x_{ij}$ mit $0 \leq i < M$ und $N-M \leq j < N$ eine Matrix $X_{h+2}$ bilden;

- Codieren jeder Zeile von $U^N_{h+2}$ auf Basis des Polarcodes der Länge N, der dieser Zeile zugeordnet ist, um so eine codierte Matrix $X^N_h$ zu erhalten, wobei die Bits $x_{ij}$ von $X^N_{h+2}$ mit $0 \leq i < M$ und $0 \leq j < N-M$ eine Matrix $X_{h+3}$ bilden, während die Bits $x_{ij}$ mit $0 \leq i < M$ und $N-M \leq j < N$ eine Matrix $X_{h+2}$ bilden;

- Übertragen der Matrix $X_{h+2}$.

3. Vorrichtung (101) nach Anspruch 1, wobei die Vorrichtung (101) ferner zu Folgendem konfiguriert ist:

- alle Bits für $x_{ij}$ mit $j \geq N-M$, die die Matrix $X_0'$ bilden, auf 0 zu setzen.

4. Vorrichtung (101) nach einem der vorhergehenden Ansprüche, wobei die Vorrichtung für den Polarcode der Länge N dazu konfiguriert ist:

- die K zuverlässigsten Positionen i mit $i < N-M$ als Positionen von Informationsbits auszuwählen;
- die restlichen N-M-K Positionen mit $i < N-M$ einzufrieren; und
- Informationsbits an einer beliebigen Position $i \geq N-M$ einzufügen.

5. Vorrichtung (101) nach einem der vorhergehenden Ansprüche 1 bis 4, wobei die Vorrichtung (101) für den Polarcode der Länge N, wobei N-M eine Potenz von 2 ist, dazu konfiguriert ist:

- die K zuverlässigsten Positionen i als nicht gefrorene Positionen aus der gefrorenen Menge von Polarcodes der Länge N-M auszuwählen, wobei nicht gefrorene Positionen Positionen von Informationsbits entsprechen;
- die restlichen N-M-K Positionen einzufrieren; und
- Informationsbits an einer beliebigen Position $i \geq N-M$ einzufügen.

6. Verfahren (900) zum Codieren einer Informationsbits enthaltenden Eingabefolge, wobei das Verfahren (900) die folgenden Schritte umfasst:

- Erzeugen (901) einer MxN-Matrix $U^N_h$, wobei M=N/2, wobei in jeder Zeile $0 \leq i < M$ von $U^N_h$ jede Bitposition $0 \leq j < M$ in Abhängigkeit von einer Menge gefrorener Bitindizes F eines Polarcodes der Länge N, der dieser Zeile zugeordnet ist, ein Informationsbit der Eingabefolge oder ein eingefrorenes Bit enthält, wobei die Bits $x_{ij}$ mit $0 \leq i < M$ und $0 \leq j < N-M$ eine Matrix $U_{h+1}$ bilden, während die Bits $x_{ij}$ mit $0 \leq i < M$ und $M \leq j < N$ eine Matrix $X_h$ bilden;

- Codieren (902) jeder Zeile von $U^N_h$ auf Basis des Polarcodes der Länge N, der dieser Zeile zugeordnet ist, um so eine codierte Matrix $X^N_h$ zu erhalten, wobei die Bits $x_{ij}$ von $X^N_h$ mit $0 \leq i < M$ und $0 \leq j < M$ eine Matrix $X_{h+1}$ bilden, während die Bits $x_{ij}$ mit $0 \leq i < M$ und $M \leq j < N$ eine Matrix $X_h$ bilden;

- Übertragen (903) der Matrix $X_h$;

- Erzeugen einer NxM-Matrix $U^N_{h+1}$, wobei in jeder Spalte $0 \leq i < M$ von $U^N_{h+1}$ jede Bitposition

$0 \leq j < M$ in Abhängigkeit von einer Menge gefrorener Bitindizes F eines Polarcodes der Länge N, der dieser Spalte zugeordnet ist, ein Informationsbit der Eingabefolge oder ein gefrorenes Bit enthält, wobei die Bits $x_{ij}$ mit $0 \leq i < M$ und $0 \leq j < N-M$ eine Matrix $U_{h+2}$ bilden, während die Bits $x_{ij}$ mit $0 \leq i < M$ und $M \leq j < N$ die Matrix $X_{h+1}$ bilden;
- Codieren jeder Spalte von $U^N_{h+1}$ auf Basis des Polarcodes der Länge N, der dieser Spalte zugeordnet ist, um so eine codierte Matrix $X^N_{h+1}$ zu erhalten, wobei die Bits $x_{ij}$ von $X^N_{h+1}$ mit $0 \leq j < M$ und $0 \leq i < N-M$ eine Matrix $X_{h+2}$ bilden, während die Bits $x_{ij}$ mit $0 \leq ij < M$ und $N-M \leq j < N$ eine Matrix $X_{h+1}$ bilden;
- Übertragen der Matrix $X_{h+1}$;

und wobei die Polarcodierung auf einer nicht-systematischen Polarcodierung basiert.

7. Verfahren (900) gemäß Anspruch 6, wobei das Verfahren (900) ferner Folgendes umfasst:

- Erzeugen einer MxN-Matrix $U^N_{h+2}$, wobei in jeder Zeile $0 \leq i < M$ von $U^N_{h+2}$ jede Bitposition $0 \leq j < N-M$ in Abhängigkeit von der Menge gefrorener Bitindizes F des Polarcodes der Länge N, der dieser Zeile zugeordnet ist, ein Informationsbit der Eingabefolge oder ein gefrorenes Bit enthält, wobei die Bits $x_{ij}$ mit $0 \leq i < M$ und $0 \leq j < N-M$ eine Matrix $U_{h+3}$ bilden, während die Bits $x_{ij}$ mit $0 \leq i < M$ und $N-M \leq j < N$ eine Matrix $X_{h+2}'$ bilden;
- Codieren jeder Zeile von $U^N_{h+2}$ auf Basis des Polarcodes der Länge N, der dieser Zeile zugeordnet ist, um so eine codierte Matrix $X^N_{h+2}$ zu erhalten, wobei die Bits $x_{ij}$ von $X^N_{h+2}$ mit $0 \leq i < M$ und $0 \leq j < N-M$ eine Matrix $X_{h+3}$ bilden, während die Bits $x_{ij}$ mit $0 \leq i < M$ und $N-M \leq j < N$ eine Matrix $X_{h+2}$ bilden;
- Übertragen der Matrix $X_{h+2}$.

8. Computerprogramm, das Programmcode umfasst, der einen Computer dazu veranlasst, eines der Verfahren der Ansprüche 6 bis 7 auszuführen, wenn der Programmcode von dem Computer ausgeführt wird.

**Revendications**

1. Appareil (101) pour coder une séquence comportant des bits d'information dans une séquence de matrices, dans lequel l'appareil (101) est configuré pour :

- générer une matrice MxN $U^N_h$, dans lequel M=N/2, dans lequel, dans chaque ligne $0 \leq i < M$ de $U^N_h$, chaque position de bit $0 \leq j < M$ contient un bit d'information de la séquence d'entrée ou un bit gelé dépendant d'un ensemble d'indices de bits gelés F d'un code polaire de longueur N associé à cette ligne, dans lequel les bits $x_{ij}$, pour $0 \leq i < M$ et $0 \leq j < N-M$ forment une matrice $U_{h+1}$, tandis que les bits $x_{ij}$ pour $0 \leq i < M$ et $M \leq j < N$ forment une matrice $X_h$ ;
- coder chaque ligne de $U^N_h$ sur la base du code polaire de longueur N associé à cette ligne, afin d'obtenir une matrice codée $X^N_h$, dans lequel les bits $x_{ij}$ de $X^N_h$ pour $0 \leq i < M$ et $0 \leq j < N-M$ forment une matrice $X_{h+1}$ tandis que les bits $x_{ij}$ pour $0 \leq i < M$ et $M \leq j < N$ forment une matrice $X_h$ ;
- transmettre la matrice $X_h$ ;
- générer une matrice NxM $U^N_{h+1}$, dans lequel, dans chaque colonne $0 \leq j < M$ de $U^N_{h+1}$, chaque position de bit $0 \leq i < N$ contient un bit d'information de la séquence d'entrée ou un bit gelé dépendant d'un ensemble d'indices de bits gelés F du code polaire de longueur N associé à cette ligne, dans lequel les bits $x_{ij}$, pour $0 \leq j < M$ et $0 \leq i < N-M$ forment une matrice $U_{h+2}$, tandis que les bits $x_{ij}$ pour $0 \leq j < M$ et $N-M \leq i < N$ forment la matrice $X_{h+1}$ ;
- coder chaque colonne de $U^N_{h+1}$ sur la base du code polaire de longueur N associé à cette colonne, afin d'obtenir une matrice codée $X^N_{h+1}$, dans lequel les bits $x_{ij}$ de $X^N_{h+1}$ pour $0 \leq j < M$ et $0 \leq i < N-M$ forment une matrice $X_{h+2}$ tandis que les bits $x_{ij}$ pour $0 \leq j < M$ et $N-M \leq j < N$ forment une matrice $X_{h+1}$ ;
- transmettre la matrice $X_{h+1}$ ; et
- dans lequel le codage polaire est basé sur un codage polaire non systématique.

2. Appareil (101) selon la revendication 1, dans lequel l'appareil (101) est également configuré pour :

- générer une matrice MxN $U^N_{h+2}$, dans lequel, dans chaque ligne $0 \leq i < M$ de $U^N_{h+2}$, chaque position de bit $0 \leq j < N-M$ contient un bit d'information de la séquence d'entrée ou un bit gelé dépendant de l'ensemble d'indices de bits gelés F du code polaire de longueur N associé à cette ligne, dans lequel les bits $x_{ij}$, pour $0 \leq i < M$ et $0 \leq j < N-M$ forment une matrice $U_{h+3}$, tandis que les bits $x_{ij}$ pour $0 \leq i < M$ et $N-M \leq j < N$ forment la matrice $X_{h+2}$ ;
- coder chaque ligne de $U^N_{h+2}$ sur la base du code polaire de longueur N associé à cette ligne, afin d'obtenir une matrice codée $X^N_{h+2}$, dans lequel les bits $x_{ij}$ de $X^N_{h+2}$ pour $0 \leq i < M$ et $0 \leq j < N-M$ forment une matrice $X_{h+3}$ tandis que les bits $x_{ij}$ pour $0 \leq i < M$ et $M \leq j < N$ forment une matrice $X_{h+2}$ ;
- transmettre la matrice $X_{h+2}$.

3. Appareil (101) selon la revendication 1, dans lequel l'appareil (101) est également configuré pour :

- mettre à 0 tous les bits $x_{ij}$ pour $j \geq N-M$ formant la matrice $X_0'$ .

**4.** Appareil (101) selon l'une quelconque des revendications précédentes, dans lequel, pour le code polaire de longueur N, l'appareil est configuré pour :

- choisir K positions les plus fiables i, avec i<N-M, comme positions des bits d'information ;
- geler les positions N-M-K restantes avec i<N-M ; et
- placer les bits d'information dans n'importe quelle position i≥N-M.

**5.** Appareil (101) selon l'une quelconque des revendications précédentes 1 à 4, dans lequel, pour le code polaire de longueur N et N-M étant une puissance de 2, l'appareil (101) est configuré pour :

- sélectionner les K positions les plus fiables i comme positions non gelées à partir de l'ensemble gelé de codes polaires de longueur N-M, dans lequel les positions non gelées correspondent aux positions des bits d'information ;
- geler les positions N-M-K restantes ; et
- placer les bits d'information dans n'importe quelle position i≥N-M.

**6.** Procédé (900) de codage d'une séquence d'entrée comportant des bits d'information, dans lequel le procédé (900) comprend les étapes :

- de génération (901) d'une matrice MxN $U^N_h$, dans lequel M=N/2, dans lequel, dans chaque ligne 0≤i<M de $U^N_h$, chaque position de bit 0≤j<M contient un bit d'information de la séquence d'entrée ou un bit gelé dépendant d'un ensemble d'indices de bits gelés F d'un code polaire de longueur N associé à cette ligne, dans lequel les bits $x_{ij}$, pour 0≤i<M et 0≤j<M forment une matrice $U_{h+1}$, tandis que les bits $x_{ij}$ pour 0≤i<M et M≤j<N forment une matrice $X_h$ ;
- de codage (902) de chaque ligne de $U^N_h$ sur la base du code polaire de longueur N associé à cette ligne, afin d'obtenir une matrice codée $X^N_h$, dans lequel les bits $x_{ij}$ de $X^N_h$ pour 0≤i<M et 0≤j<M forment une matrice $X_{h+1}$ tandis que les bits $x_{ij}$ pour 0≤i<M et M≤j<N forment une matrice $X_h$ ;
- de transmission (903) de la matrice $X_h$ ;
- de génération d'une matrice NxM $U^N_{h+1}$, dans lequel, dans chaque colonne 0≤j<M de $U^N_{h+1}$, chaque position de bit 0≤i<N contient un bit d'information de la séquence d'entrée ou un bit gelé dépendant d'un ensemble d'indices de bits gelés F du code polaire de longueur N associé à cette colonne, dans lequel les bits $x_{ij}$, pour 0≤j<M et 0≤i<N-M forment une matrice $U_{h+2}$, tandis que les bits $x_{ij}$ pour 0≤j<M et N-M≤i<N forment la matrice $X_{h+1}$ ;
- de codage de chaque colonne de $U^N_{h+1}$ sur la base du code polaire de longueur N associé à cette colonne, afin d'obtenir une matrice codée $X^N_{h+1}$, dans lequel les bits $x_{ij}$ de $X^N_{h+1}$ pour 0≤j<M et 0≤i<N-M forment une matrice $X_{h+2}$ tandis que les bits $x_{ij}$ pour 0≤j<M et N-M≤j<N forment une matrice $X_{h+1}$ ;
- de transmission de la matrice $X_{h+1}$ ;

et dans lequel le codage polaire est basé sur un codage polaire non systématique.

**7.** Procédé (900) selon la revendication 6, dans lequel le procédé (900) comprend également :

- la génération d'une matrice MxN $U^N_{h+2}$, dans lequel, dans chaque ligne 0≤i<M de $U^N_{h+2}$, chaque position de bit 0≤j<N-M contient un bit d'information de la séquence d'entrée ou un bit gelé dépendant de l'ensemble d'indices de bits gelés F du code polaire de longueur N associé à cette ligne, dans lequel les bits $x_{ij}$, pour 0≤i<M et 0≤j<N-M forment une matrice $U_{h+3}$, tandis que les bits $x_{ij}$ pour 0≤i<M et N-M≤j<N forment une matrice $X_{h+2}'$ ;
- le codage de chaque ligne de $U^N_{h+2}$ sur la base du code polaire de longueur N associé à cette ligne, afin d'obtenir une matrice codée $X^N_{h+2}$, dans lequel les bits $x_{ij}$ de $X^N_{h+2}$ pour 0≤i<M et 0≤j<N-M forment une matrice $X_{h+3}$ tandis que les bits $x_{ij}$ pour 0≤i<M et M≤j<N forment une matrice $X_{h+2}$ ;
- la transmission de la matrice $X_{h+2}$.

**8.** Programme informatique comprenant un code de programme qui amène un ordinateur à exécuter l'un des procédés selon les revendications 6 à 7 lorsque le code de programme est exécuté par l'ordinateur.

Fig.1

100

F

$u$ → | ENCODER | $x$ → | Channel | $y$ → | DECODER | → $\hat{x}, \hat{u}$

101    102    103

Fig.2

Fig.3

Fig.4

EP 4 026 249 B1

$X_2'$

$U_3$

$X_1$     $X_0$

Fig.5

Fig.6

Fig.7

Fig.8

$\underline{900}$

Generating an MxN matrix $U^N_h$.

901

Encoding the matrix $U^N_h$ to obtain an encoded matrix $X^N_h$ formed by a matrix $X_{h+1}{}'$ and a matrix $X_h$.

902

Transmitting the matrix $X_h$.

903

**Fig. 9**

<u>1000</u>

$\Big\downarrow$

```
┌─────────────────────────────────────────────┐
│  Propagating LLRs of a matrix Λ_w to obtain   │
1001                   an LLRs matrix.          │
└─────────────────────────────────────────────┘
```

Propagating LLRs of a matrix $\Lambda_w$ to obtain an LLRs matrix.

1001

Concatenating an interleaver to the LLRs matrix to obtain a matrix $\Lambda'_w$.

1002

Prepending the matrix $\Lambda'_w$ to a matrix $\Lambda_{w-1}$ to obtain a matrix $D_w$.

1003

Decoding the matrix $D_w$ based on a polar code to obtain a matrix $\Gamma_w$.

1004

Computing an updated matrix $\Lambda_{w-1}$.

1005

**Fig. 10**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **E. ARIKAN**. Channel polarization: A method for constructing capacity achieving codes for symmetric binary-input memoryless channels. *IEEE Trans. on Inf. Theory*, July 2009, vol. 55 (7), 3051-3073
- **I. TAL** ; **A. VARDY**. List decoding of polar codes. *IEEE Transactions on Information Theory*, May 2015, vol. 61 (5), 2213-2226
- **A. BALATSOUKAS-STIMMING** ; **M. B. PARIZI** ; **A. BURG**. LLR-Based Successive Cancellation List Decoding of Polar Codes. *IEEE Transactions on Signal Processing*, 01 October 2015, vol. 63 (19), 5165-5179
- **B. P. SMITH et al.** Staircase Codes: FEC for 100 Gb/s OTN. *IEEE/OSA Journal of Lightwave Technology*, January 2012, vol. 30 (1)
- **B. FENG et al.** A novel high-rate polar-staircase coding scheme. *arXiv:1805.10082*, 2018
- **L. ZHOU et al.** Performance Analysis of Soft Decoding Algorithms for Polar-Staircase Coding Scheme. *2018 10th International Conference on Wireless Communications and Signal Processing (WCSP), Hangzhou*, 2018
- **DOU**. *Soft-Decision Based Sliding-Window Decoding of Staircase Codes*